(19) Europäisches Patentamt
European Patent Office
Office européen des brevets

(11) EP 3 367 449 B1

(12) EUROPEAN PATENT SPECIFICATION

(45) Date of publication and mention of the grant of the patent:
**17.07.2019 Bulletin 2019/29**

(51) Int Cl.:
***H01L 35/22*** *(2006.01)* ***H01L 35/34*** *(2006.01)*

(21) Application number: **18154037.8**

(22) Date of filing: **30.01.2018**

(54) **THERMOELECTRIC CONVERSION MATERIAL AND PRODUCING METHOD THEREOF**

THERMOELEKTRISCHES UMWANDLUNGSMATERIAL UND HERSTELLUNGSVERFAHREN DAFÜR

MATÉRIAU DE CONVERSION THERMOÉLECTRIQUE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.02.2017 JP 2017034270**

(43) Date of publication of application:
**29.08.2018 Bulletin 2018/35**

(73) Proprietor: **Hitachi, Ltd.**
**Chiyoda-ku**
**Tokyo 100-8280 (JP)**

(72) Inventors:
- **Nishide, Akinori**
  **Tokyo, 100-8280 (JP)**
- **Hayakawa, Jyun**
  **Tokyo, 100-8280 (JP)**
- **Kurosaki, Ken**
  **Osaka, 565-0871 (JP)**
- **Tanusilp, Sora-at**
  **Osaka, 565-0871 (JP)**

(74) Representative: **Strehl Schübel-Hopf & Partner**
**Maximilianstrasse 54**
**80538 München (DE)**

(56) References cited:
**JP-A- H08 151 269** **US-A- 5 547 598**
**US-A1- 2004 187 905** **US-A1- 2012 097 205**

- **SORA-AT TANUSILP ET AL: "Ytterbium Silicide (YbSi 2 ): A Promising Thermoelectric Material with a High Power Factor at Room Temperature", PHYSICA STATUS SOLIDI. RAPID RESEARCH LETTERS, vol. 12, no. 2, 12 December 2017 (2017-12-12), page 1700372, XP055493245, DE ISSN: 1862-6254, DOI: 10.1002/pssr.201700372**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

BACKGROUND OF THE INVENTION

FIELD OF THE INVENTION

The present invention relates to a thermoelectric conversion material and a producing method thereof.

BACKGROUND ART

Recently, while interest in an energy issue increases, effective utilization of waste heat which is generated in the process of using primary energy comes into an important object, in addition to an use of renewable energy. The energy quantity of waste heat occupies about 60% of primary energy. Most of the waste heat is generated in extensive places such as a plant, industrial infrastructure, commercial products, mobility.

A heat pump technology progresses, and thus cases of using waste heat as heat are increased and demands for converting waste heat into electricity and using this electricity as power are increased. As a system of realizing power conversion of heat, a large-scale Rankine cycle (turbine) power generation system which is a steam engine that operates by high-pressure steam of a liquid medium is the mainstream. However, since waste heat is widely dispersed, the waste heat is not suitable for a system in which power conversion is concentrically performed at one place.

As a technology for solving the above-described problem, a thermoelectric conversion system using the Seebeck effect in which a voltage is generated by a temperature difference between materials is known. Since the thermoelectric conversion system does not include a driving unit such as a turbine, the size of the thermoelectric conversion system can be reduced with scalability and the thermoelectric conversion system is suitable for heat recovery at a temperature in a wide range.

Therefore, the thermoelectric conversion system can be applied to power generation which uses a heat source in a limited narrow space such as a vehicle. In particular, development of a thermoelectric conversion system for a vehicle, which is performed in order to improve fuel efficiency as measures for the European $CO_2$ emissions regulation (Euro6-7) started in 2017 proceeds fast by vehicle manufacturers.

However, regarding commercialization of the thermoelectric conversion system, improvement of power conversion efficiency and reduction of cost are important problems . In order to improve the power conversion efficiency, it is important to increase a material performance index ZT of a thermoelectric conversion material which is a component for determining output power of the thermoelectric conversion system and is the most important component in the system. For example, when the system is applied to a vehicle, the thermoelectric conversion system utilizes an engine waste heat as a heat source. Thus, a thermoelectric conversion material which has high ZT at the middle to high temperature of 300°C to 600°C and is cheap is required.

The maximum output P of a thermoelectric conversion module which is the core of the thermoelectric conversion technology is determined by a product of heat flux of heat flowing into the module and a conversion efficiency $\eta$ of the thermoelectric conversion material. The heat flux depends on a module structure which is suitable for the thermoelectric conversion material.

The conversion efficiency $\eta$ depends on the dimensionless performance index ZT of the thermoelectric conversion material. The performance index ZT is represented by $ZT=\{S^2/(\kappa\rho)\}T$ (S: Seebeck coefficient, $\rho$: electric resistivity, $\kappa$: thermal conductivity, and T: temperature). Thus, the maximum output P of the thermoelectric conversion module is improved by increasing S (Seebeck coefficient), $\rho$ (electric resistivity), and $\kappa$ (thermal conductivity) of the thermoelectric conversion material.

The thermoelectric conversion material for the medium to high temperature of 300°C to 600°C can be roughly classified into a metal material and a compound (semiconductor) material. Among the above materials, an Co-Sb alloy and a Pb-Te compound semiconductor are representative and high ZT thereof is reported. In addition, silicide of Si, Mn-Si, Mg-Si, and Al-Mn-Si (disclosed in JP-A-2012-174849) are reported although ZT is lower than those of the above two kinds of materials. Furthermore US5547598 discloses a thermoelectric semiconductor material comprising Si crystals and a crystal of metal silicide selected from the group consisting of Fe, Co, Cr, Mn and Ni. In addition US2012/0097205 discloses a magnesium-silicon composite material which contains $Mg_2Si$ as an intermetallic compound which has a figure of merit of 0.665 at 866K. Furthermore a lanthanide silicide thermoelectric material such as ytterbium silicide is known from JPH08151269A.

There are the following three important points to be exemplified in a case of considering a practical use of the thermoelectric conversion material having high ZT. The first is the high Clarke number with low cost. The second is non-toxic. The third is high strength and toughness as a structural material. As materials having a probability of satisfying the above factors, Si or silicide is considered.

However, as described above, the Si silicide material in the related art does not have sufficiently high ZT in comparison to those of a Co-Sb alloy and a Pb-Te compound semiconductor. Accordingly, as one of objects in a state where Si and silicide are put into practical use, an increase in ZT is exemplified.

## SUMMARY OF THE INVENTION

As described above, the performance index ZT of the thermoelectric conversion material is represented by the expression of $ZT=\{S^2/(\kappa\rho)\}T$. In order to increase the performance index ZT, reduction of the thermal conductivity $\kappa$ or an increase of the output factor ($S^2/\rho$) is required. The thermal conductivity $\kappa$ is reduced in a manner that a crystal grain size is reduced so as to nano-crystallize the material. However, the nano-crystallized material causes the output factor ($S^2/\rho$) to be reduced in comparison to that of the general polycrystal.

Accordingly, in order to increase the performance index ZT of Si or silicide, it is desired that a specific condition which allows a large output factor ($S^2/\rho$) to be obtained in a state where the thermal conductivity $\kappa$ is reduced by reducing the crystal grain size is found.

An example of the disclosure is a thermoelectric conversion material which includes a crystal grain of Si and a crystal grain of Yb-Si silicide.

The average crystal grain size of each of Si and Yb-Si silicide is greater than 0 and 100 nm or smaller.

Another example of the present invention is a producing method of a thermoelectric conversion material. The producing method thereof includes forming a multilayer film in a manner that a stacking unit which is configured with a Si layer of greater than 0 and 100 nm or smaller, and a Yb-Si silicide layer of greater than 0 and 100 nm or smaller is stacked on a substrate, and forming a multilayer film including crystal grains of Si and crystal grains of Yb-Si silicide which have an average crystal grain size of greater than 0 and 100 nm or smaller, by heating the multilayer film.

Still another example of the present invention is a producing method of a thermoelectric conversion material. The producing method thereof includes generating a nano-crystallized ribbon by cooling a material including a Si element and a Yb element while the material is injected from a nozzle, producing powder by milling the ribbon, and forming thermoelectric materials including a Si crystal grain and a Yb-Si silicide crystal grain which have an average crystal grain size of greater than 0 and 100 nm or smaller, by sintering the powder under predetermined pressure.

According to the aspect of the present invention, it is possible to provide a silicide thermoelectric conversion material which exhibits an excellent performance index ZT. Problems, components, and advantageous effects other than the above descriptions may be clarified by the descriptions of the following embodiment.

## BRIEF DESCRIPTION OF THE DRAWINGS

Fig. 1A illustrates a configuration example of a thermoelectric conversion module.
Fig. 1B illustrates a flowchart of a producing method of a multilayer film.
Fig. 1C schematically illustrates a multilayer film structure before a heat treatment.
Fig. 2 illustrates a measurement result of an organizational structure of a thermoelectric conversion material (multilayer film sample).
Fig. 3 illustrates a relationship between a film thickness percentage and a composition ratio of the multilayer film.
Fig. 4 illustrates an output factor P of a sample having a different film thickness percentage a, at T of 50°C.
Fig. 5 illustrates a flowchart of a producing method of the thermoelectric conversion material.
Fig. 6 illustrates a result of XRD of the thermoelectric conversion material.
Fig. 7 is a schematic state diagram of Si and $YbSi_2$ in the vicinity of a eutectic point and illustrates a SEM image of a thin piece obtained by mixing Si and Yb and ultrarapidly cooling the mixture of a liquid phase.

## DETAILED DESCRIPTION OF THE INVENTION

Hereinafter, an embodiment of the present invention will be described with reference to the accompanying drawings. The embodiment is just an example for realizing the present invention, and is to be careful not to limit the technical range of the present invention. The common components in the drawings are denoted by the same reference signs.

### Outline

In the disclosure, an adequate combination and the adequate quantity (adequate composition) of elements, an adequate combination of crystal structures, and an adequate producing method and adequate dimensions are provided as means for increasing an output factor of composite nanocrystal silicide. According to the disclosure, an adequate method is used for producing a thin film or a bulk of composite nanocrystal silicide, and thus it is possible to provide a thermoelectric conversion material which has a high performance index and is non-toxic and cheap, by controlling a crystal structure of each phase thereof.

The core of the thermoelectric conversion technology is a thermoelectric conversion module. Fig. 1A illustrates a configuration example 100 of the thermoelectric conversion module. The thermoelectric conversion module 100 includes a high-temperature side insulating substrate 101, a low-temperature side insulating substrate 102, a plurality of high-temperature side electrodes 103, a plurality of low-temperature side electrodes 104, a plurality of p-type thermoelectric conversion elements (p-type semiconductor elements) 105, and a plurality of n-type thermoelectric conversion elements (n-type semiconductor elements) 106.

The high-temperature side insulating substrate 101 and the low-temperature side insulating substrate 102 face each other. The plurality of high-temperature side electrodes 103, the plurality of low-temperature side electrodes 104, the plurality of p-type thermoelectric conversion elements 105, and the plurality of n-type thermoelectric conversion elements 106 are disposed on the surfaces of the high-temperature side insulating substrate 101 and the low-temperature side insulating substrate 102, which face each other.

Specifically, the plurality of high-temperature side electrodes 103 which are separated from each other are formed on the surface of the high-temperature side insulating substrate 101, which faces the low-temperature side insulating substrate 102. The plurality of low-temperature side electrodes 104 which are separated from each other are formed on the surface of the low-temperature side insulating substrate 102, which faces the high-temperature side insulating substrate 101.

Each of the p-type thermoelectric conversion elements 105 is connected to the high-temperature side electrode 103 and the low-temperature side electrode 104. Each of the n-type thermoelectric conversion elements 106 is connected to the high-temperature side electrode 103 and the low-temperature side electrode 104. The p-type thermoelectric conversion elements 105 are connected in series and the n-type thermoelectric conversion elements 106 are also connected in series. The p-type thermoelectric conversion elements 105 and the n-type thermoelectric conversion elements 106 are alternately arranged.

The thermoelectric conversion module 100 is disposed to be close to a heat source . The high-temperature side insulating substrate 101 is directed toward the heat source. The thermoelectric conversion module 100 generates electricity by a temperature difference which occurs in the thermoelectric conversion module 100. Specifically, the p-type thermoelectric conversion element 105 generates an electromotive force from a low-temperature side of a temperature gradient toward a high-temperature side thereof. The n-type thermoelectric conversion element 106 generates an electromotive force from the high-temperature side of the temperature gradient toward the low-temperature side thereof.

The p-type thermoelectric conversion elements 105 and the n-type thermoelectric conversion elements 106 are alternately connected in series. Thus, the sum total of the electromotive forces in the p-type thermoelectric conversion elements 105 and the n-type thermoelectric conversion elements 106 in accordance with the temperature gradient is set as an electromotive force of the thermoelectric conversion module 100.

Next, the principle of improving conversion performance of a thermoelectric conversion material which is formed from a silicide compound will be described. Firstly, a general relationship between thermoelectric conversion performance and an electronic state will be described. The performance index of a thermoelectric conversion material uses a dimensionless number referred to as ZT, as the index. The performance index thereof is obtained by the following expression (1).

$$ZT=S^2/\rho\kappa\times T \quad (1)$$

S: Seebeck coefficient
κ: thermal conductivity
ρ: electric resistivity
T= operation temperature

As the Seebeck coefficient S becomes higher and as electric resistivity and thermal conductivity become smaller, the performance index ZT is increased. The Seebeck coefficient S and the electric resistivity ρ are physical quantities determined in accordance with an electronic state of a substance. The Seebeck coefficient S and the electronic state has a relationship as represented by the following expression (2) .

$$S\propto(1/N(E_F))\times(\partial N(E)/\partial E),\ E=E_F \quad (2)$$

$E_F$: Fermi level

E: binding energy
N: state density

According to the expression (2), the Seebeck coefficient S is inversely proportional to state density (DOS)N($E_F$) at the Fermi level and is proportional to an energy gradient ($\partial N(E)/\partial E$) of the state density. Thus, it is understood that a substance in which state density of the Fermi level is small and the state density is rapidly increased has a high Seebeck coefficient S. Most of silicide functioning as a semiconductor has a high Seebeck coefficient based on this principle.

The electric resistivity ρ and the electronic state has a relationship as represented by the following expression (3).

$$1/\rho=\lambda_F v_F N(E_F) \quad (3)$$

$\lambda_F$: mean free path of an electron at the Fermi level
$v_F$: velocity of an electron at the Fermi level

According to the expression (3), the electric resistivity ρ is inversely proportional to state density N($E_F$) at the Fermi level. Thus, when the Fermi level is at an energy position at which the absolute value of the state density N is high, the electric resistivity ρ is small. In a case where a material structure is configured in a scale which is smaller than the mean free path $\lambda_F$ of an electron in the expression (3), electrons at any boundary surface are scattered and the electric resistivity ρ is increased.

Next, the thermal conductivity κ will be described. The thermal conductivity κ can be considered as the sum of lattice thermal conductivity $\kappa_p$ regarding transfer of heat by lattice vibration and electron thermal conductivity $\kappa_e$ regarding transfer of heat by using electrons as a medium. $\kappa_e$ is increased by the Wiedeman Franz's law as electric resistivity becomes lower, and $\kappa_e$ depends on the electronic state. The electron thermal conductivity $\kappa_e$ can be reduced by controlling carrier density. Generally, when the carrier density is smaller than $10^{20}/cm^3$, $\kappa_e$ is the minimum and $\kappa_p$ is dominant.

However, the decrease of the carrier density causes an increase of the electric resistivity. Thus, it is expected that ZT with respect to the carrier density has the maximum value, in accordance with balance between the increase of the electric resistivity and the decrease of the thermal conductivity based on the definition of ZT. $\kappa_p$ depends on the size of the lattice. In conclusion, the thermal conductivity κ can be qualitatively expressed as follows.

$$\kappa=k_f\times C_p\times\zeta \quad (4)$$

$C_p$: specific heat of sample at constant pressure, ζ: density of material

$$k_f=d^2/\tau_f \quad (5)$$

d: crystal grain size
$\tau_f$: time until heat is transferred from the back surface of a grain to the front surface

As represented by the expressions (4) and (5), the thermal conductivity κ is reduced as the crystal grain size d of a sample becomes smaller. It is considered that suppression of $k_f$ corresponds to suppression of $\kappa_p$.

Thus, if the crystal grain size of the sample is reduced while the electronic state of silicide is controlled, it is possible to largely improve the thermoelectric conversion performance. However, regarding a silicide thermoelectric conversion material which is examined in the related art, if the thermal conductivity κ is reduced by reducing the crystal grain size, the electric resistivity p is increased. Since the output factor ($S^2/\rho$) in the performance index ZT={$S^2/(\kappa\rho)$}T is reduced by reducing the crystal grain size, the performance index ZT is not increased as much as expected.

Considering the above situation, the inventors focused on composite nanocrystal silicide. In the disclosure, the composite nanocrystal silicide is polycrystal of silicide having a plurality of crystal phases. The crystal grain size thereof is a nanometer order. The silicide is a compound of silicon and transition metal.

As described above, it is possible to reduce the thermal conductivity κ by reducing the crystal grain size. Further, since silicide having a specific structure and a plurality of crystal phases is formed, a high output factor ($S^2/\rho$) which is not allowed to be obtained in silicide having a single crystal phase is realized while the low thermal conductivity κ is maintained.

The inventors focused on Si/YbSi composite nanocrystal silicide among many kinds of silicide. In the disclosure, a composite material of silicon and silicide is also referred to as composite silicide. The inventors focused on a Si phase which exhibits a high Seebeck coefficient S and $YbSi_2$ as a compound which can adjust carrier concentration with respect to Si and can decrease resistance of Si, in Si/YbSi composite nanocrystal silicide.

The inventors found that composite nanocrystal silicide exhibits a high output factor ($S^2/\rho$) in a case where the composite nanocrystal silicide formed from Si and Yb has a specific structure. Specifically, composite nanocrystal silicide which includes crystal grains of Si and crystal grains of Yb-Si silicide exhibits a high output factor ($S^2/\rho$). In particular, composite nanocrystal silicide in which $YbSi_2$ nanocrystal is precipitated in a matrix of Si exhibits a high output factor ($S^2/\rho$). Further, composite nanocrystal silicide in which the volume ratio between Si nanocrystal and $YbSi_2$ nanocrystal is adequately adjusted exhibits a high output factor ($S^2/\rho$). Yb-Si silicide may include an Al element for adjusting the carrier.

As an example, a crystal grain size of each crystal phase is controlled to be greater than the mean free path $\lambda_F$ of an electron and be smaller than the mean free path $\lambda Ph$ of a phonon. Thus, it is possible to decrease the thermal conductivity without increasing the electric resistivity. The oriented crystal phase can suppress scattering of electrons at an interface between crystal grains and suppress an increase of the electric resistivity. In addition, a combination of crystal phases which lattice-match with each other at a bonding interface can suppress scattering of electrons at the bonding interface and suppress an increase of the electric resistivity.

In the composite nanocrystal silicide in the disclosure, even if the thermal conductivity $\kappa$ is reduced by reducing the crystal grain size (or film thickness) up to being smaller than 20 nm, the output factor ($=S^2/\rho$) is slightly decreased or is significantly increased in contrast with silicide in the related art. The composite nanocrystal silicide in the disclosure exhibits a p-type or n-type output factor ($=S^2/\rho$) in accordance with the combination of the crystal structure.

If the average crystal grain size of the composite nanocrystal silicide in the disclosure, in which the composition is adequately adjusted is set to be smaller than 100 nm, it is possible to effectively improve the performance index ZT. If the average crystal grain size is set to be 10 nm or greater and smaller than 50 nm, the performance index ZT may be further improved. If the average crystal grain size is set to be from 10 nm to 20 nm, the performance index ZT may be further improved.

This is similarly applied when the film thickness in the multilayer film structure is controlled. If the film thickness is set to be smaller than 100 nm, it is possible to effectively improve the performance index ZT. If the film thickness is set to be 10 nm or greater and smaller than 50 nm, the performance index ZT may be further improved. If the film thickness is set to be from 10 nm to 20 nm, the performance index ZT may be further improved. If the crystal grain size or the film thickness is out of the above-described range thereof, elements are scattered and thus it is difficult to maintain a desired composite nanocrystal structure.

In composite nanocrystal silicide formed from Yb and Si, the composition ratio is selected, for example, in a range of Yb:Si=1:99 (at%) to Yb:Si=17:83 (at%) (eutectic point). The composition in this composition range is in the vicinity of the eutectic point at which two phases of a Si phase and a $YbSi_2$ phase can be provided together. Thus, it is possible to produce composite nanocrystal of Si and $YbSi_2$ by selecting a suitable producing process.

In the following descriptions, an element combination, an element composition ratio, a combination of crystal phases, dimensions, a producing method, and the like which are suitable for increasing the output factor of the composite nanocrystal silicide will be more specifically described. The thermoelectric conversion material in the disclosure can be produced in a form of a thin film or a bulk.

Example 1

In the following descriptions, production of a sample and a measurement result of the sample will be described. The inventors produced plural kinds of thermoelectric conversion materials having a multilayer structure. Specifically, the inventors produced plural kinds of silicide multilayer films. Each of the thermoelectric conversion materials was produced in a manner that a plurality of layers were stacked by a magnetron sputtering method, and then a heat treatment was performed in vacuum. The inventors evaluated the crystal structure, the organizational structure, and thermoelectric conversion characteristics of each of the plural kinds of produced thermoelectric conversion materials.

A producing method of each of the multilayer films will be described. As illustrated in the flowchart in Fig. 1B, the multilayer film is produced as follows. A stacking unit (stacking cycle) configured by layers having different compositions is stacked on a substrate so as to form a multilayer film (S11). Then, a heat treatment is performed on the multilayer film on the substrate, so as to form a multilayer film configured with silicide layers which are cyclically stacked and have different crystal phases (S12).

Firstly, a Si/Yb-Si multilayer film is produced under an atmosphere of ultra-high vacuum which is equal to or smaller than $10^{-6}$ Pa, by a magnetron sputtering method. As a stacking method of the multilayer film, a method other than the sputtering method may be employed.

A Si layer is generated from a target (referred to as a Si target) of a combination of elements, which is the same as that of the above layer. A Yb-Si silicide layer is generated from a target (referred to as a Yb-Si target) of a combination of elements, which is the same as that of the above layer.

The multilayer film structure of the produced multilayer film is marked as follows.

Si/Yb-Si multilayer film: Sub.//[Si(n-a*n)/Yb-Si(a*n)]*D/n
n indicates a stacking cycle and the unit thereof is nm. a indicates the film thickness percentage of Yb-Si silicide in the stacking cycle. Sub. ahead of "//" indicates the type of a substrate. An element after "//" indicates the type of a sputtering target (corresponding to the type of a layer to be produced).

Values (n-a*n) and (a*n) in parentheses indicate the film thickness of a Si layer and a Yb-Si silicide layer, respectively. The unit thereof is nm. A Si silicide layer is generated from a Si target. A Si-Yb silicide layer is generated from a Yb-Si target. D indicates the film thickness of the produced multilayer film, and the unit thereof is nm. D/n indicates the number of stacking cycles.

Fig. 1C schematically illustrates the multilayer film structure before the heat treatment, which is marked in accordance with the above-described marks. A Si layer 113 and Yb-Si layer 115 are alternately stacked on a single crystal sapphire substrate 111. The Si layer 113 has a film thickness d_A. The Yb-Si layer 115 has a film thickness d_B. Relationships of n=d_A+d_B and a=d_B/(d_A+d_B) are established.

After the Si/Yb-Si multilayer film is produced, the heat treatment is performed so as to diffuse the Yb element. Thus, the amount of the diffused element in each of the layers is adjusted. In particular, the composition of the Yb-Si silicide layer is changed by the heat treatment.

As an example, a Si/Yb-Si multilayer film was produced in a different condition.

A film was formed on a single crystal sapphire substrate which had been cut out along a (0001) plane, so as to form a cyclic multilayer film of the Si/Yb-Si multilayer film. Then, the heat treatment was performed so as to diffuse the Yb element. Thus, the amount of Yb in each of the layers was adjusted, and the desired multilayer film sample was obtained. Specifically, after the film was produced, the heat treatment was performed at a temperature of 600°C for one hour.

The inventors evaluated the crystal structure and the organizational structure of each of the obtained multilayer film samples (thermoelectric conversion materials) by XRD and SIMS. The electric resistivity ρ and the Seebeck coefficient S were measured by ZEM manufactured by ULVAC RIKO, Inc.

Fig. 2 illustrates a measurement result of the organizational structure of a thermoelectric conversion material (multilayer film sample) of the produced one film. This multilayer film is marked as follows.
Sapp.//[Si(n-a*n)/Yb-Si(a*n)]*D/n (D=200 nm, n=20 nm, a=0.2)

The thickness of the multilayer film is 200 nm. The stacking cycle n is 20 nm. The thickness of the Si layer is 16 nm. The thickness of the Yb-Si layer is 4 nm.

Fig. 2 illustrates a SIMS profile of the sample subjected to the heat treatment at 600°C. Focusing on the spectrum of the Yb element, it is understood that the spectrum is periodically increased and decreased in a film thickness direction. The periodic increase and decrease of strength in the spectrum of the Si element was not observed.

From the above results, it is understood that a multilayer structure in which the Yb element is diffused by the heat treatment at 600°C and the amount of the Yb element is increased and decreased in the film thickness direction is formed in the sample. The similar tendency could be also confirmed in other samples.

The inventors analyzed the organizational structure of a thermoelectric conversion material having a different stacking cycle n, by SIMS. The stacking cycle n of the material was adjusted in a range of 5 nm ≤ n ≤ 100 nm. As a result, the inventors found that adjustment of the stacking cycle was important as a condition which allowed a periodic multilayer structure to be formed after the heat treatment.

In order to obtain the multilayer structure, it is important to set the stacking cycle n when the film is produced and after the heat treatment is performed to be greater than 5 nm and smaller than 50 nm. Further, in a case where the stacking cycle n is from 10 nm to 20 nm, it is possible to obtain the more suitable multilayer structure.

Fig. 3 illustrates a relationship between the film thickness percentage and the composition ratio of the above multilayer film. It is understood that a ratio Si:Yb in all the samples can be selected in a range of 100:0 (at%) to 81:19 (at%) in a state where the film thickness percentage a of Yb-Si silicide is controlled.

The result of the output factor P of the Si/Yb-Si multilayer film, which is measured at room temperature will be described below. Fig. 4 illustrates the output factor P of a sample having a different film thickness percentage a, atT of 50°C. A multilayer film having a different film thickness percentage was produced and the heat treatment at 600°C was performed. Each of produced samples before the heat treatment has the following multilayer structure.
Sapp.//[Si(n-a*n)/Yb-Si(a*n)]*D/n (D=200 nm, n=20 nm, a=0.2, 0.6, and 1.0)

Each of the samples has a Si/Yb-Si multilayer film on a single crystal sapphire substrate which had been cut out along a (0001) plane. The Si/Yb-Si multilayer film has a film thickness of 200 nm and a stacking cycle of 20 nm. The film thickness percentage of Yb-Si in the samples is respectively 0.2, 0.6, and 1.0.

The output factor P has the maximum value when the Yb-Si film thickness percentage is 60% (a=0.6) . When the Yb-Si film thickness percentage is 20% (a=0.2) and the Yb-Si film thickness percentage is 100% (a=1.0), the output factor P is decreased. From this result, it is found that if the Yb-Si film thickness percentage is adjusted to be in a range of 0.2 < a < 1.0, it is possible to obtain a Si/Yb-Si multilayer film which causes the output factor P to be increased even though the percentage is out of the above range.

The inventors measured the output factor of Mn silicide produced by a similar method. The value thereof was about 300 $\mu W/K^2m$. In a case where the Yb-Si film thickness percentage is in a range of $0.4 \leq a \leq 0.9$, the output factor P of the Si/Yb-Si multilayer film can exceed the value. This range corresponds to a range of 7.6 at% ≤ Yb molar fraction ≤ 17.0 at%.

As described above, it is possible to suitably set the entire composition of a thermoelectric conversion material and the constant (stacking cycle n, film thickness percentage a) for defining a structure of a composite nanomaterial, and to increase the output factor of silicide used as a thermoelectric conversion material.

Example 2

In Example 2, a producing method of a thermoelectric conversion material, which is different from that in Example 1 will be described. With reference to the flowchart in Fig. 5, in the producing method in this example, Si and Yb are used as raw materials and each of the raw materials is weighed so as to obtain a desired composition ratio (S21). The raw materials are put into a BN crucible, and are dissolved at a high frequency in an atmosphere of an inert gas. A nano-crystallized alloy ribbon (flexible thin plate having a band shape) is obtained in a manner that dissolved Si and Yb are sprayed on a copper disk which rotates at a high speed, from a nozzle attached to the BN crucible (S22).

The nano-crystallized alloy ribbon is milled and powder is put into a carbon dies or a tungsten carbide dies. The powder is sintered under pressure of 40 MPa to 5 GPa in an atmosphere of an inert gas while a pulse current is applied (S23). The pressing direction is an uniaxial direction. Plastic deformation is caused, and thus crystal orientation is performed. Regarding a sintering temperature condition, the highest temperature of 700°C to 1200°C is held for 3 minutes to 180 minutes. Then, an aimed thermoelectric conversion material is obtained by performing cooling up to room temperature.

The inventors evaluated the average crystal grain size of the polycrystal thermoelectric conversion material obtained by the above method, by a scanning electron microscope and XRD (X - ray diffraction). Further, the crystal structure of the obtained thermoelectric conversion material was evaluated by a transmission electron microscope and XRD. Figs. 6 and 7 illustrate results.

Fig. 6 illustrates results of XRD. Fig. 6 illustrates a situation in which two phases of Si and $YbSi_2$ in the thermoelectric conversion material are provided together. Fig. 7 is a schematic diagram 700 of a state diagram of Si and $YbSi_2$ in the vicinity of the eutectic point and illustrates SEM images 711, 713, and 715 of a thin piece obtained by mixing Si and Yb in the composition illustrated in the state diagram and by ultrarapidly cooling the mixture of a liquid phase.

Firstly, the schematic diagram 700 of the state diagram of Si and $YbSi_2$ in the vicinity of the eutectic point will be described. A vertical axis indicates a temperature and a horizontal axis indicates a molar fraction of Yb. A vertical axis on the left side indicates an axis of Si:Yb=100:0 (at%) . A vertical axis on the right side indicates an axis of Si:Yb=66.67:33.33 (at%).

A region L indicates a liquid-phase region. A region surrounded by a broken straight line 701 and solid arcs 702 and 703 indicates a coexistence region of the liquid phase and the solid phase. A vertex at which the two arcuate solid lines 702 and 703 intersect with each other is referred to as the eutectic point. The composition ratio between Si and $YbSi_2$ is 1:1 in volume ratio.

If a material having a composition which is adjusted to be a composition on the Si excess side based on the eutectic point is melted and then is cooled, a structure in which $YbSi_2$ is precipitated in a matrix of Si is formed. If a material having a composition which is adjusted to be a composition on the Yb excess side based on the eutectic point is melted and cooled, a structure in which Si is precipitated in a $YbSi_2$ matrix is formed. A diameter and a structure of the precipitated Si or $YbSi_2$ are determined in accordance with a cooling rate and the composition ratio of the melted raw materials.

In particular, if the cooling rate is increased, and thus rapid cooling is performed from the liquid phase up to room temperature, crystal growth can be stopped before the crystal grain of the precipitated Si or $YbSi_2$ sufficiently grows. Accordingly, it is possible to obtain a composite structure having fine precipitated Si or fine precipitated $YbSi_2$.

Based on the above descriptions, a mixture of Si and Yb, which is obtained by weighing the raw materials so as to obtain a molar ratio Si:Yb of 95:5, 90:10, and 83:17 (at%) is melted by being heated to become the liquid phase. Then, rapid cooling is performed. Fig. 7 illustrates observation images 711, 612, and 713 obtained by evaluating the diameter of the obtained precipitate with SEM. Focusing on the observation image 711 of a case of Si:Yb=95:5, it is understood that a white $YbSi_2$ precipitate is provided in a dark Si matrix. The diameter of the $YbSi_2$ precipitate was evaluated. As a result, the diameter thereof was about 20 nm.

From this, it is understood that a fine precipitate is obtained from the liquid phase by ultrarapid cooling and the precipitate is nanocrystal having a diameter of about 20 nm. It is understood that, if the molar fraction of Yb is increased, the volume ratio of the precipitated $YbSi_2$ is increased, from the SEM observation images 711, 612, and 713. The SEM observation image 713 of a case where Si:Yb at the eutectic point is 83:17 (at%) shows a form in which crystal of $YbSi_2$

sufficiently grows and crystals thereof are joined.

## Claims

1. A thermoelectric conversion material comprising:

   a crystal grain of Si; and
   a crystal grain of Yb-Si silicide,
   wherein an average crystal grain size of each of Si and Yb-Si silicide is greater than 0 and 100 nm or smaller.

2. The thermoelectric conversion material according to claim 1,
   wherein a ratio (Si:Yb) is in a range of 99.0:1.0 (at%) to 83.0:17.0 (at%).

3. The thermoelectric conversion material according to claim 1,
   wherein a ratio (Si:Yb) is in a range of 92.4:7.6 (at%) to 83.0:17.0 (at%).

4. The thermoelectric conversion material according to claim 1,
   wherein a multilayer structure in which a layer of Si (113)
   and a layer of Yb-Si silicide (115) are provided is provided, and
   a stacking cycle in the multilayer structure is 10 nm or greater and smaller than 50 nm.

5. The thermoelectric conversion material according to claim 1,
   wherein a multilayer structure in which a layer of Si (113) and a layer of Yb-Si silicide (115) are alternately stacked is provided, and
   a film thickness percentage of the layer of the Yb-Si silicide in the stacking cycle of the multilayer structure is in a range of greater than 0.2 and smaller than 1.0.

6. The thermoelectric conversion material according to claim 1,
   wherein a multilayer structure in which a layer of Si (113) and a layer of Yb-Si silicide (115) are alternately stacked is provided, and
   a film thickness percentage of the layer of the Yb-Si silicide in the stacking cycle of the multilayer structure is in a range of 0.4 to 0.9.

7. A producing method of a thermoelectric conversion material, the method comprising:

   forming a multilayer film in a manner that a stacking unit which is
   configured with a Si layer (113) of greater than 0 and 100 nm or smaller, and a Yb-Si silicide layer (115) of greater than 0 and 100 nm or smaller is stacked on a substrate (111) ; and
   forming a multilayer film including crystal grains of Si and crystal grains of Yb-Si silicide which have an average crystal grain size of greater than 0 and 100 nm or smaller, by heating the multilayer film.

8. The producing method of a thermoelectric conversion material according to claim 7,
   wherein a thickness of the stacking unit is 10 nm or greater and smaller than 50 nm.

9. The producing method of a thermoelectric conversion material according to claim 7,
   wherein a ratio of a thickness of the Yb-Si silicide layer to a thickness of the stacking unit is in a range of greater than 0.2 and smaller than 1.0.

10. A producing method of a thermoelectric conversion material, the method comprising:

    generating a nano-crystallized ribbon by cooling a material including a Si element and a Yb element while the material is injected from a nozzle;
    producing powder by milling the ribbon; and
    forming thermoelectric materials including a Si crystal grain and a Yb-Si silicide crystal grain which have an average crystal grain size of greater than 0 and 100 nm or smaller, by sintering the powder under predetermined pressure.

**Patentansprüche**

1. Thermoelektrisches Umwandlungsmaterial, umfassend:

   Kristallkörner aus Si; und
   Kristallkörner aus Yb-Si-Silizid,
   wobei eine jeweils durchschnittliche Kristallkorngröße von Si und Yb-Si-Silizid mehr als 0 und 100 nm oder weniger beträgt.

2. Thermoelektrisches Umwandlungsmaterial nach Anspruch 1,
   wobei ein Verhältnis (Si:Yb) in einem Bereich von 99,0:1,0 (at%) bis 83,0:17,0 (at%) liegt.

3. Das thermoelektrische Umwandlungsmaterial nach Anspruch 1,
   wobei ein Verhältnis (Si:Yb) in einem Bereich von 92,4:7,6 (at%) bis 83,0:17,0 (at%) liegt.

4. Thermoelektrisches Umwandlungsmaterial nach Anspruch 1,

   wobei eine Mehrschichtstruktur, in der eine Schicht aus Si (113) und eine Schicht aus Yb-Si-Silizid (115) vorgesehen sind, vorgesehen ist, und
   eine Stapelperiode in der Mehrschichtstruktur 10 nm oder größer und kleiner als 50 nm ist.

5. Thermoelektrisches Umwandlungsmaterial nach Anspruch 1,

   wobei eine Mehrschichtstruktur, in der eine Schicht aus Si (113) und eine Schicht aus Yb-Si-Silizid (115) abwechselnd gestapelt sind, vorgesehen ist, und
   ein prozentualer Filmdickenanteil der Schicht des Yb-Si-Silizids im Stapelzyklus der Mehrschichtstruktur in einem Bereich von mehr als 0,2 und weniger als 1,0 liegt.

6. Thermoelektrisches Umwandlungsmaterial nach Anspruch 1,

   wobei eine Mehrschichtstruktur, in der eine Schicht aus Si (113) und eine Schicht aus Yb-Si-Silizid (115) abwechselnd gestapelt sind, vorgesehen ist, und
   ein prozentualer Schichtdickenanteil der Schicht des Yb-Si-Silizids im Stapelzyklus der Mehrschichtstruktur in einem Bereich von 0,4 bis 0,9 liegt.

7. Herstellungsverfahren für ein thermoelektrisches Umwandlungsmaterial, wobei das Verfahren umfasst:

   Bilden eines Mehrschichtfilms in einer Weise, dass eine Stapeleinheit, die aus einer Si-Schicht (113) von mehr als 0 und 100 nm oder weniger und einer Yb-Si-Silizidschicht (115) von mehr als 0 und 100 nm oder weniger gebildet ist, auf einem Substrat (111) gestapelt wird; und
   Bilden eines Mehrschichtfilms, der Kristallkörner aus Si und Kristallkörner aus Yb-Si-Silizid enthält, die jeweils eine durchschnittliche Kristallkorngröße von mehr als 0 und 100 nm oder weniger aufweisen, durch Erwärmen des Mehrschichtfilms.

8. Herstellungsverfahren eines thermoelektrischen Umwandlungsmaterials nach Anspruch 7,
   wobei eine Dicke der Stapeleinheit 10 nm oder mehr und weniger als 50 nm beträgt.

9. Herstellungsverfahren eines thermoelektrischen Umwandlungsmaterials nach Anspruch 7,
   wobei ein Verhältnis einer Dicke der Yb-Si-Silizidschicht zu einer Dicke der Stapeleinheit in einem Bereich von mehr als 0,2 und weniger als 1,0 liegt.

10. Herstellungsverfahren für ein thermoelektrisches Umwandlungsmaterial, wobei das Verfahren umfasst:

    Erzeugen eines nanokristallinen Bands durch Auskühlen eines Materials, das ein Si-Element und ein Yb-Element enthält, während das Material aus einer Düse gespritzt wird;
    Herstellen von Pulver durch Mahlen des Bands; und
    Bilden von thermoelektrischen Materialien, die Si-Kristallkörner und Yb-Si-Silicid-Kristallkörner umfassen, die eine durchschnittliche Kristallkorngröße von mehr als 0 und 100 nm oder weniger aufweisen, durch Sintern des Pulvers unter einem vorbestimmten Druck.

**Revendications**

1. Matériau de conversion thermoélectrique comprenant :

   un grain cristallin de Si ; et
   un grain cristallin de siliciure de Yb-Si,
   dans lequel une taille moyenne de grain cristallin de chacun du Si et du siliciure de Yb-Si est supérieure à 0 et 100 nm ou plus petite.

2. Matériau de conversion thermoélectrique selon la revendication 1, dans lequel un rapport (Si:Yb) est dans une plage de 99,0:1,0 (%at) à 83,0:17,0 (%at).

3. Matériau de conversion thermoélectrique selon la revendication 1, dans lequel un rapport (Si:Yb) est dans une plage de 92,4:7,6 (%at) à 83,0:17,0 (%at).

4. Matériau de conversion thermoélectrique selon la revendication 1, dans lequel une structure multicouche dans laquelle une couche de Si (113) et une couche de siliciure de Yb-Si (115) sont prévues est prévue, et
   un cycle d'empilage dans la structure multicouche est 10 nm ou supérieur et plus petit que 50 nm.

5. Matériau de conversion thermoélectrique selon la revendication 1, dans lequel une structure multicouche dans laquelle une couche de Si (113) et une couche de siliciure de Yb-Si (115) sont empilées de manière alternée est prévue, et un pourcentage d'épaisseur de film de la couche du siliciure de Yb-Si dans le cycle d'empilage de la structure multicouche est dans une plage de supérieur à 0,2 et inférieur à 1,0.

6. Matériau de conversion thermoélectrique selon la revendication 1, dans lequel une structure multicouche dans laquelle une couche de Si (113) et une couche de siliciure de Yb-Si (115) sont empilées de manière alternée est prévue, et un pourcentage d'épaisseur de film de la couche du siliciure de Yb-Si dans le cycle d'empilage de la structure multicouche est dans une plage de 0,4 à 0,9.

7. Procédé de production d'un matériau de conversion thermoélectrique, le procédé comprenant :

   la formation d'un film multicouche d'une manière telle qu'une unité d'empilage qui est configurée avec une couche de Si (113) de supérieur à 0 et 100 nm ou plus petite, et une couche de siliciure de Yb-Si (115) de supérieur à 0 et 100 nm ou plus petite est empilée sur un substrat (111) ; et
   la formation d'un film multicouche incluant des grains cristallins de Si et des grains cristallins de siliciure de Yb-Si qui ont une taille moyenne de grain cristallin de supérieur à 0 et 100 nm ou plus petite, par chauffage du film multicouche.

8. Procédé de production d'un matériau de conversion thermoélectrique selon la revendication 7, dans lequel une épaisseur de l'unité d'empilage est 10 nm ou supérieure et plus petite que 50 nm.

9. Procédé de production d'un matériau de conversion thermoélectrique selon la revendication 7, dans lequel un rapport d'une épaisseur de la couche de siliciure de Yb-Si sur une épaisseur de l'unité d'empilage est dans une plage de supérieur à 0,2 et plus petit que 1,0.

10. Procédé de production d'un matériau de conversion thermoélectrique, le procédé comprenant :

    la génération d'un ruban nanocristallisé par refroidissement d'un matériau incluant un élément Si et un élément Yb alors que le matériau est injecté depuis une buse ;
    la production d'une poudre par broyage du ruban ; et
    la formation de matériaux thermoélectriques incluant un grain cristallin de Si et un grain cristallin de siliciure de Yb-Si qui ont une taille moyenne de grain cristallin de supérieure à 0 et 100 nm ou plus petite, par frittage de la poudre sous une pression prédéterminée.

FIG. 1A

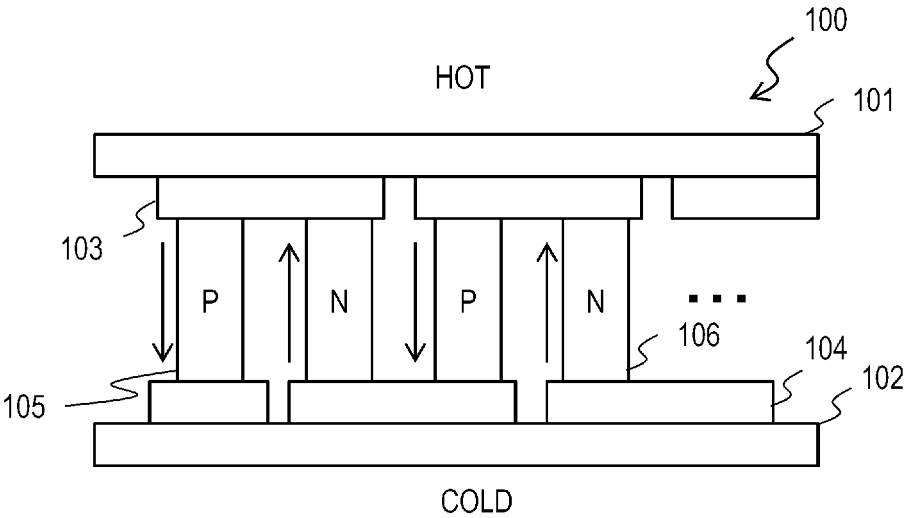


FIG. 1B

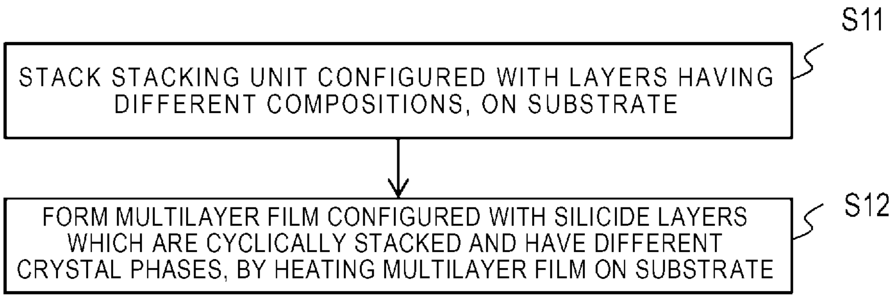


FIG. 1C

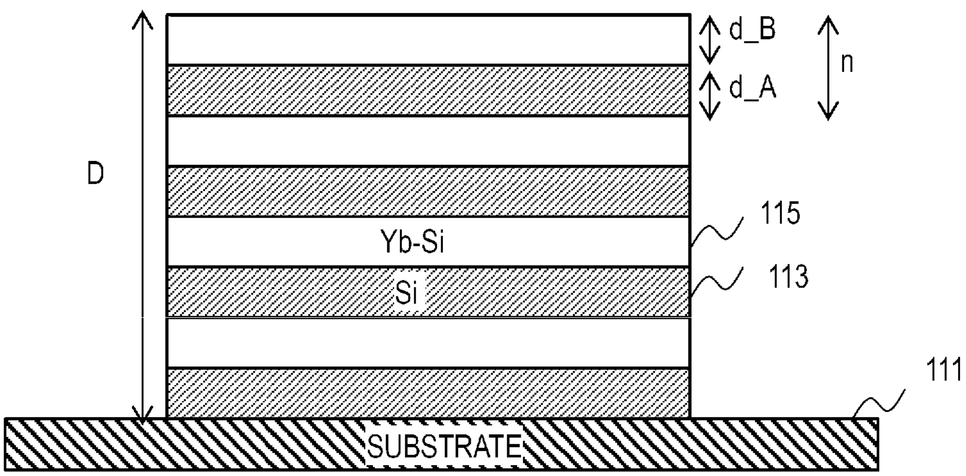

FIG. 2

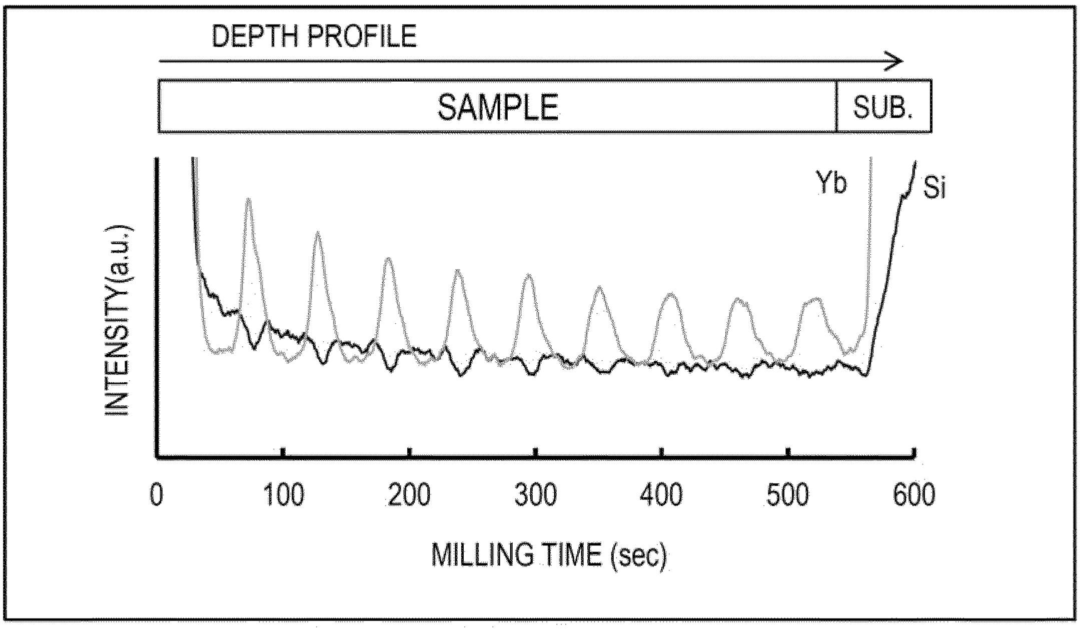
DEPTH PROFILE
SAMPLE
SUB.
Yb
Si
INTENSITY(a.u.)
0
100
200
300
400
500
600
MILLING TIME (sec)

FIG. 3

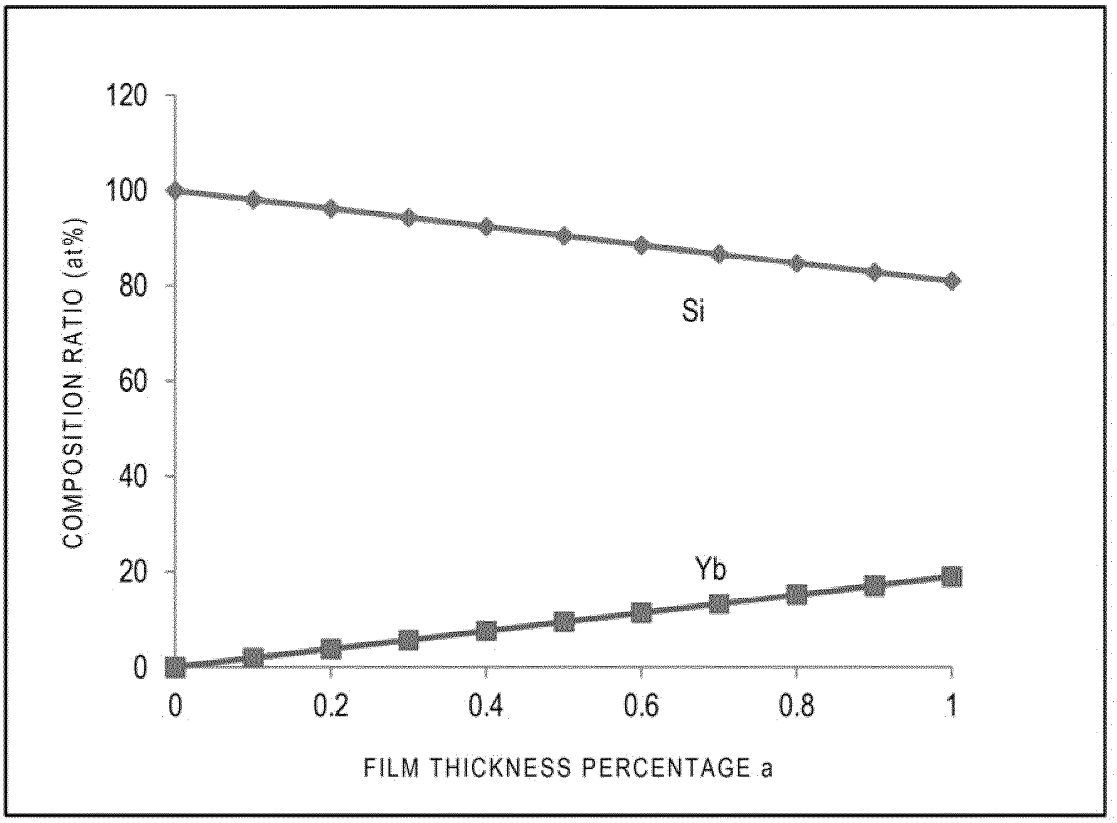
120
100
80
60
40
20
0
COMPOSITION RATIO (at%)
Si
Yb
0
0.2
0.4
0.6
0.8
1
FILM THICKNESS PERCENTAGE a

FIG. 4

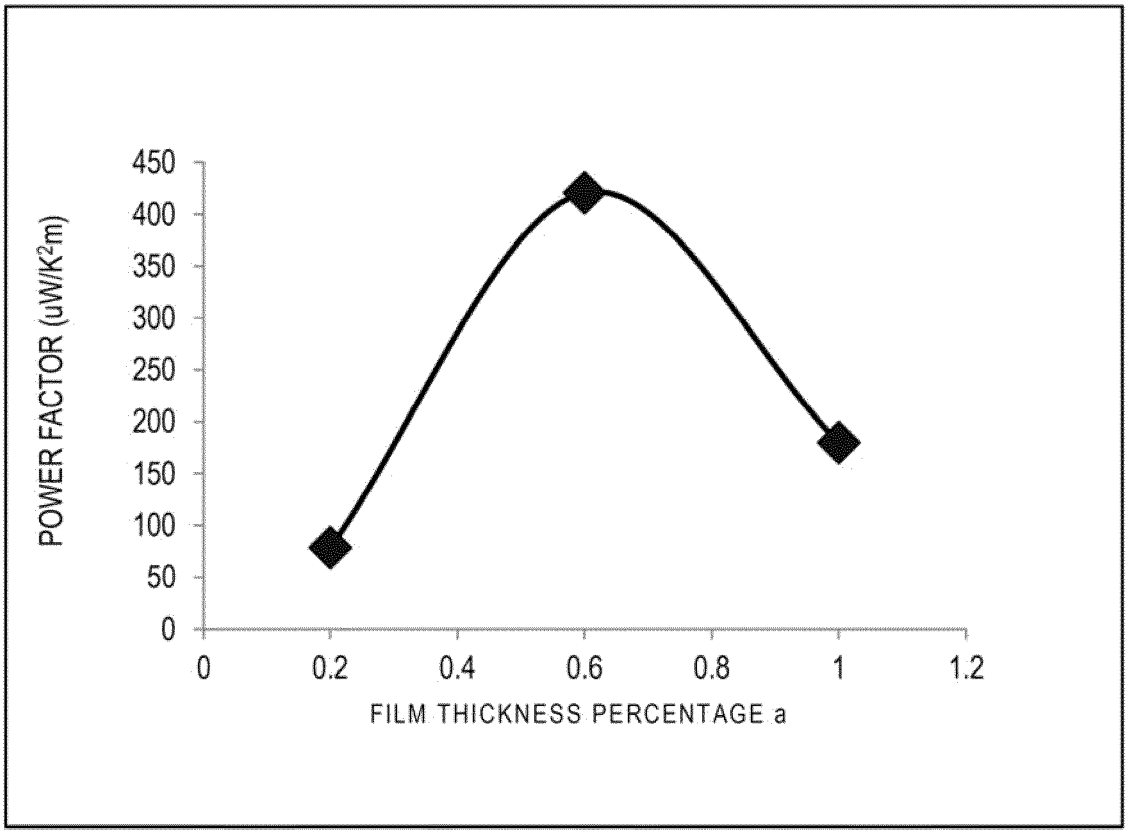
450
400
350
300
250
200
150
100
50
0
POWER FACTOR (uW/K²m)
0
0.2
0.4
0.6
0.8
1
1.2
FILM THICKNESS PERCENTAGE a

FIG. 5

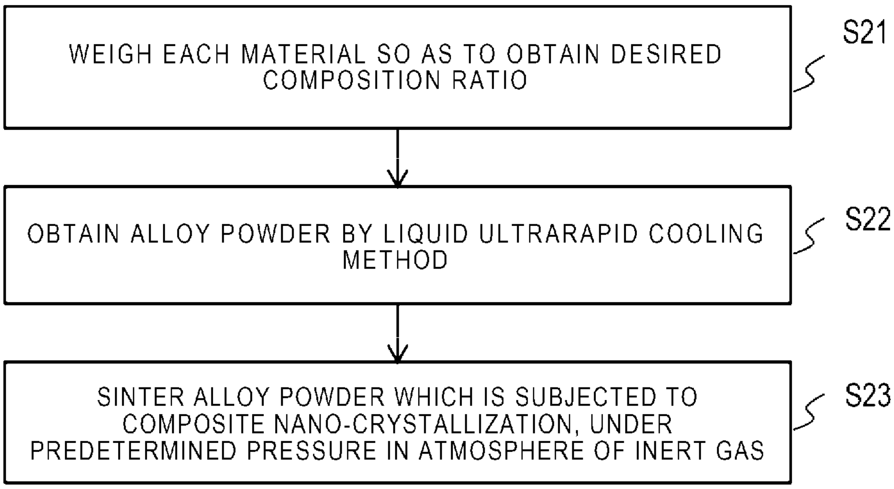
WEIGH EACH MATERIAL SO AS TO OBTAIN DESIRED COMPOSITION RATIO
S21
OBTAIN ALLOY POWDER BY LIQUID ULTRARAPID COOLING METHOD
S22
SINTER ALLOY POWDER WHICH IS SUBJECTED TO COMPOSITE NANO-CRYSTALLIZATION, UNDER PREDETERMINED PRESSURE IN ATMOSPHERE OF INERT GAS
S23

FIG. 6

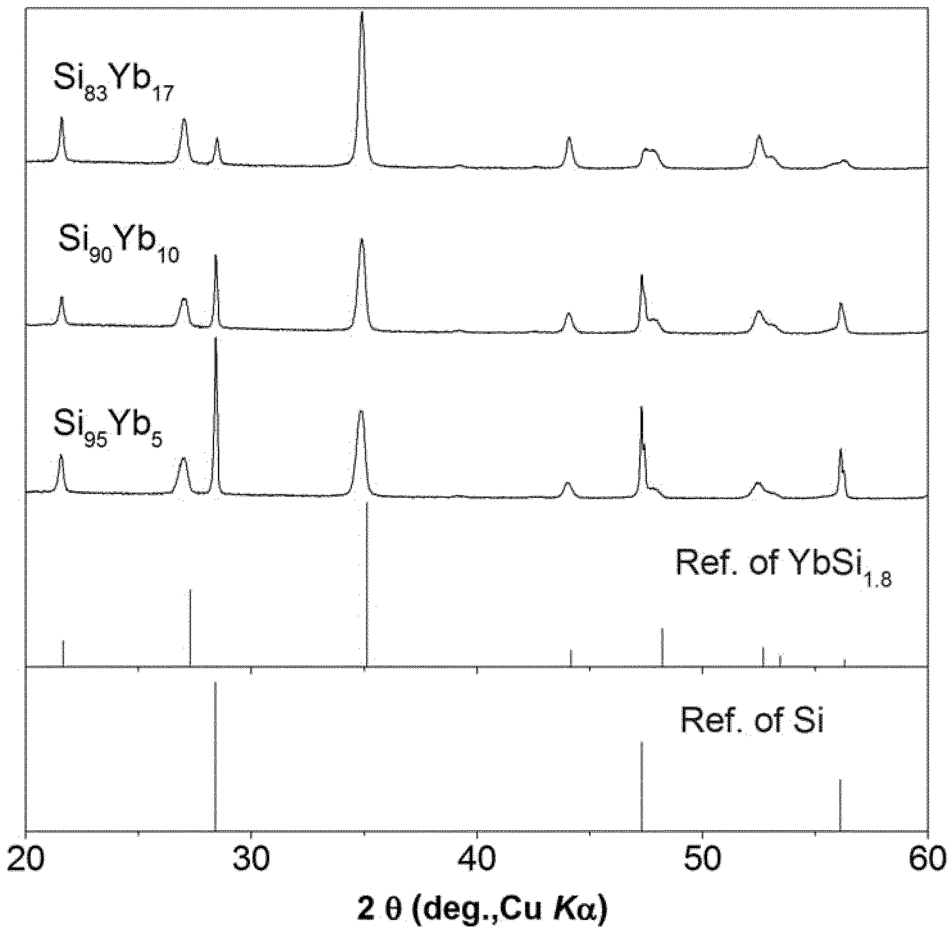
Si83Yb17
Si90Yb10
Si95Yb5
Ref. of YbSi1.8
Ref. of Si
20
30
40
50
60
2 θ (deg.,Cu Kα)

FIG. 7

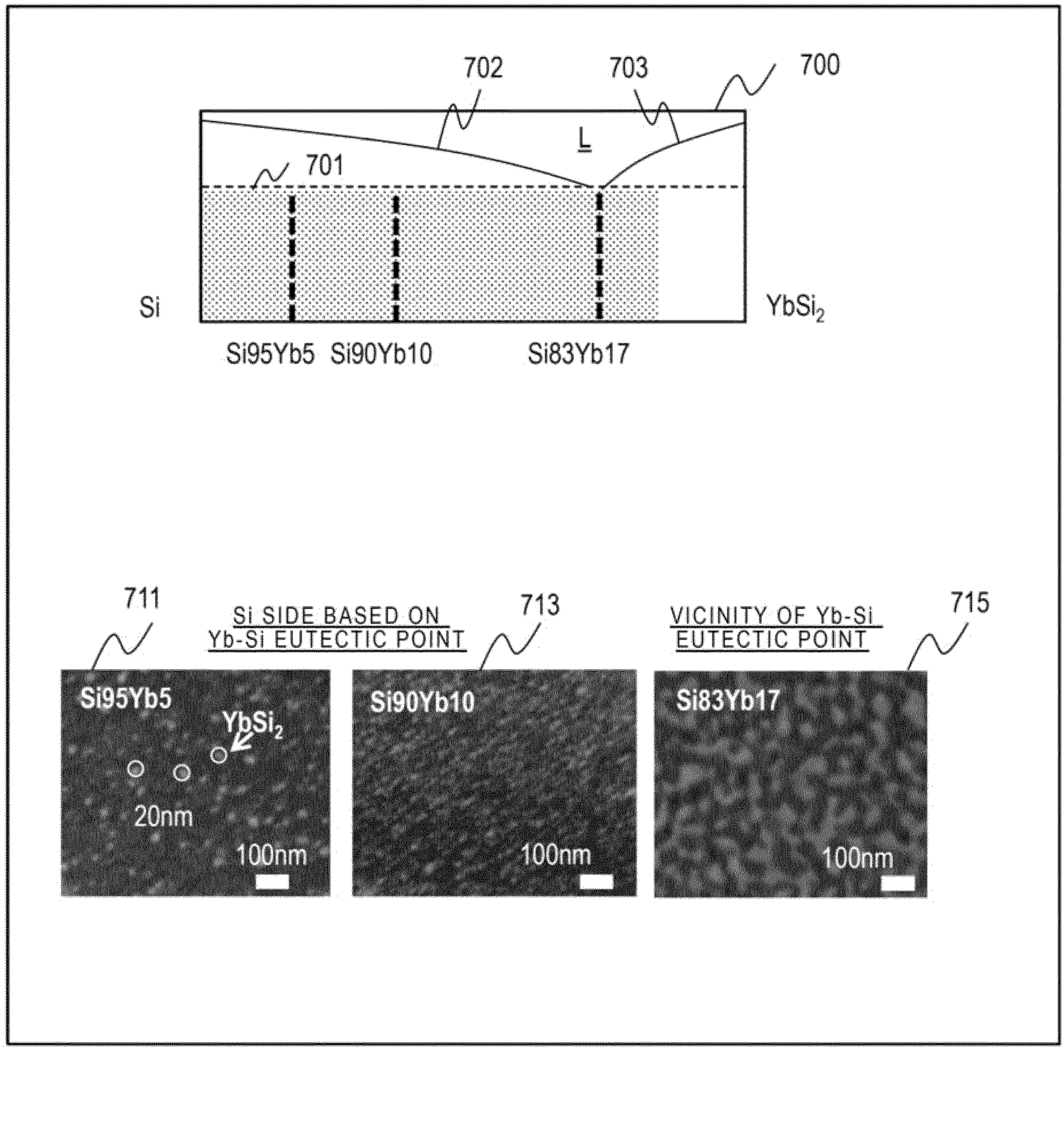
702
703
700
L
701
Si
YbSi2
Si95Yb5
Si90Yb10
Si83Yb17
711
Si SIDE BASED ON Yb-Si EUTECTIC POINT
713
VICINITY OF Yb-Si EUTECTIC POINT
715
Si95Yb5
YbSi2
20nm
100nm
Si90Yb10
100nm
Si83Yb17
100nm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012174849 A
- US 5547598 A
- US 20120097205 A
- JP H08151269 A